# EUROPÄISCHE PATENTSCHRIFT

(11) **EP 0 586 895 B1**
(45) Veröffentlichungstag und Bekanntmachung des Hinweises auf die Patenterteilung: **23.04.1997**
(21) Anmeldenummer: 93112675.9
(22) Anmeldetag: 07.08.1993
(51) Int. Cl.: H03G 11/00

(54) **Begrenzerverstärkerschaltung für eine NF-Spannung**
Limiter amplifier circuit for an audio signal
Circuit d'amplification limiteur pour un signal basse fréquence

(30) Priorität: 11.09.1992 DE 4230479
(43) Veröffentlichungstag der Anmeldung: 16.03.1994
(73) Patentinhaber: ROBERT BOSCH GMBH, 70442 Stuttgart (DE)
(72) Erfinder: Klemme, Dietmar, Dipl.-Ing., D-13349 Berlin (DE)

(56) Entgegenhaltungen:
- DE-B- 1 113 247
- US-A- 4 877 981

## Beschreibung

Die Erfindung geht von einer Begrenzerverstärkerschaltung nach dem Oberbegriff des Anspruchs 1 aus.

Es ist eine Begrenzerverstärkerschaltung bekannt (Robert Bosch GmbH, KF 168, Edition 02.1992, Bl. 2-8, 2-9, 5-2), die von einem bestimmten Pegel der niederfrequenten Eingangssignalspannung an in die Sättigung gesteuert wird. Diese als Clipping bezeichnete Art der Begrenzung hat zum Beispiel bei Senderschaltungen für Funkgeräte den Nachteil, daß zwar die Ausgangssignalspannung einen bestimmten Maximalwert nicht überschreitet, daß aber ein nachgeschaltetes Tiefpaßfilter als Sprungantwort auf die begrenzte Ausgangssignalspannung ein Überschwingen erzeugt. Dadurch kann es bei der Hochfrequenzübertragung zu Nachbarkanalstörungen kommen.

Der Erfindung liegt die Aufgabe zugrunde, eine Begrenzerschaltung nach dem Oberbegriff des Anspruchs 1 derart weiterzubilden, daß die Ausgangsspannung des NF-Verstärkers bei Übersteuerung so beschaffen ist, daß die Sprungantwort eines nachgeschalteten Tiefpaßfilters nicht zu einer Erhöhung der Signalamplitude führt.

Diese Aufgabe wird durch eine Begrenzerverstärkerschaltung mit den Merkmalen des Anspruchs 1 gelöst. Damit ist der Vorteil verbunden, daß die beim übersteuern des NF-Verstärkers durch die Sprungantwort eines nachgeschalteten Tiefpaßfilters verursachte Amplitudenerhöhung nicht nur vermieden wird, sondern daß die Ausgangsamplitude des nachgeschalteten Tiefpaßfilters bei der Übersteuerung sogar sinkt. Es ist daher nicht notwendig, die Modulationsempfindlichkeit zur Vermeidung einer Hubüberschreitung durch die Sprungantwort des der Begrenzerverstärkerschaltung nachgeschalteten Tiefpaßfilters wie beim Einsatz eines herkömmlichen Begrenzerverstärkers zu reduzieren.

Ein weiterer Vorteil besteht darin, daß die Begrenzerverstärkerschaltung einer Huberhöhung durch das Hochpaßverhalten des Modulators einer PLL-Schaltung bei niederfrequenter Rechteckansteuerung entgegenwirkt. Weiterhin ist es auch vorteilhaft, daß die Hubreduzierung ohne spürbare Verzögerungs- oder Erholzeiten arbeitet. Auch eine durch den Temperaturgang der Begrenzerverstärkerschaltung eventuell notwendig werdende Hubreduzierung erfolgt automatisch. Besonders vorteilhaft ist eine Begrenzerverstärkerschaltung nach Anspruch 7, bei der auf eine aufwendige Bereitstellung einer positiven und einer negativen Betriebsspannung für den ersten und zweiten Verstärker verzichtet werden kann.

Ausführungsbeispiele der Erfindung sind in der Zeichnung an Hand mehrerer Figuren dargestellt und werden im folgenden näher erläutert. Es zeigen
- Fig. 1: ein Blockschaltbild einer erfindungsgemäßen Begrenzerverstärkerschaltung in einer ersten Ausführung,
- Fig. 2: ein Blockschaltbild einer erfindungsgemäßen Begrenzerverstärkerschaltung in einer zweiten Ausführung,
- Fig. 3: ein ausführliches Schaltbild der Begrenzerverstärkerschaltung gemäß der zweiten Ausführung,
- Fig. 4 a: ein Diagramm des Übertragungsverhaltens der Begrenzerverstärkerschaltung nach Fig. 1 oder Fig. 2 in linearer Ausführung ohne Schaltschwelle bei 100%iger Eingangsaussteuerung,

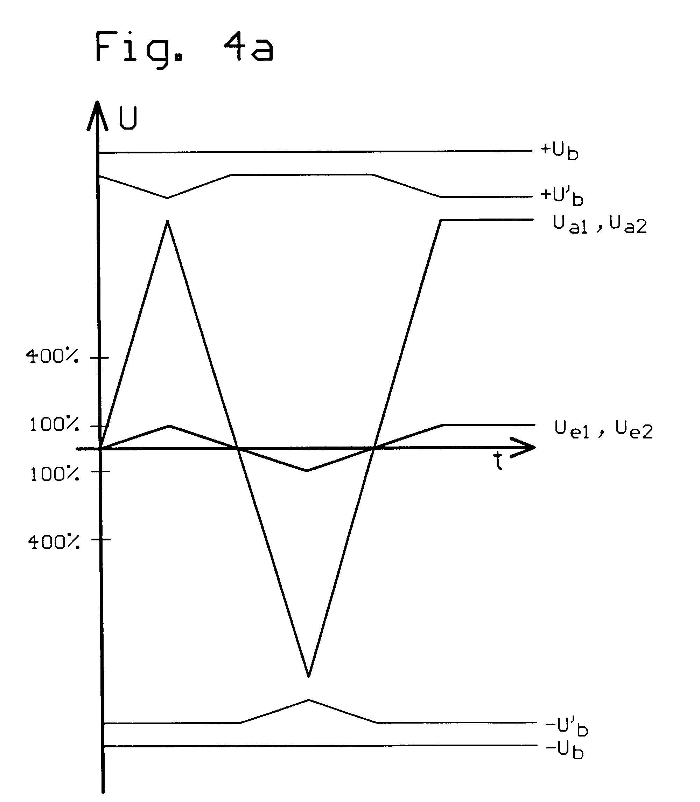

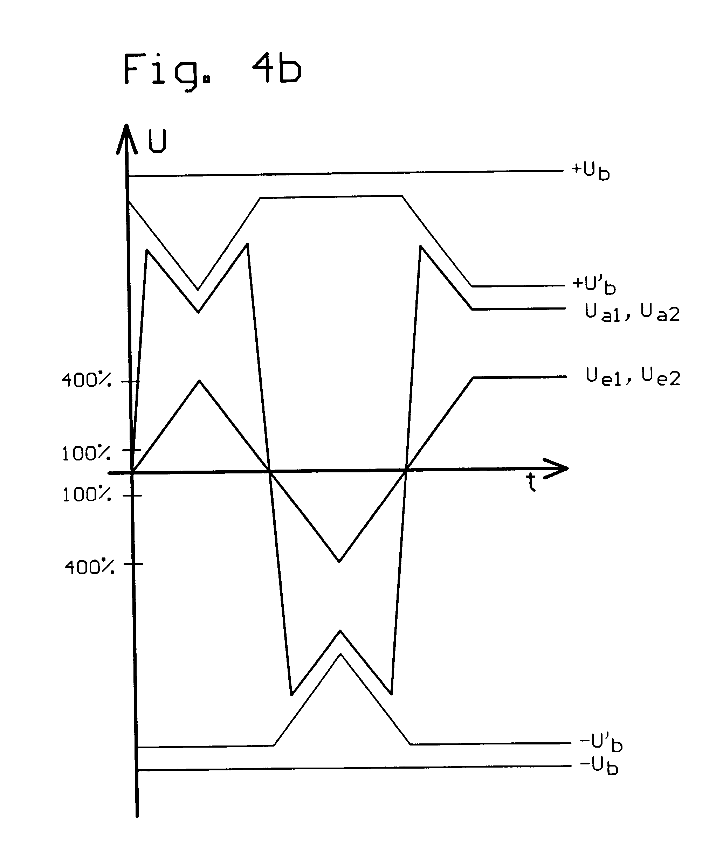

- Fig. 4 b: bei 400%iger Eingangsaussteuerung,

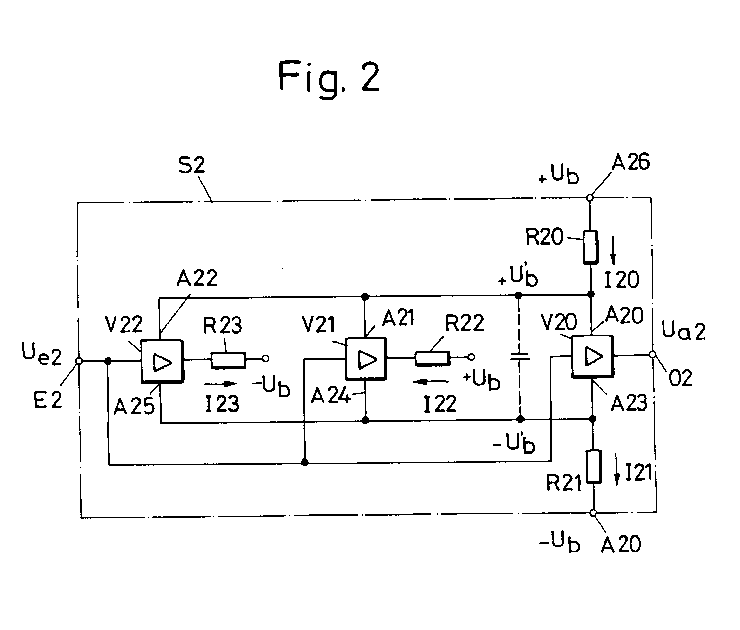

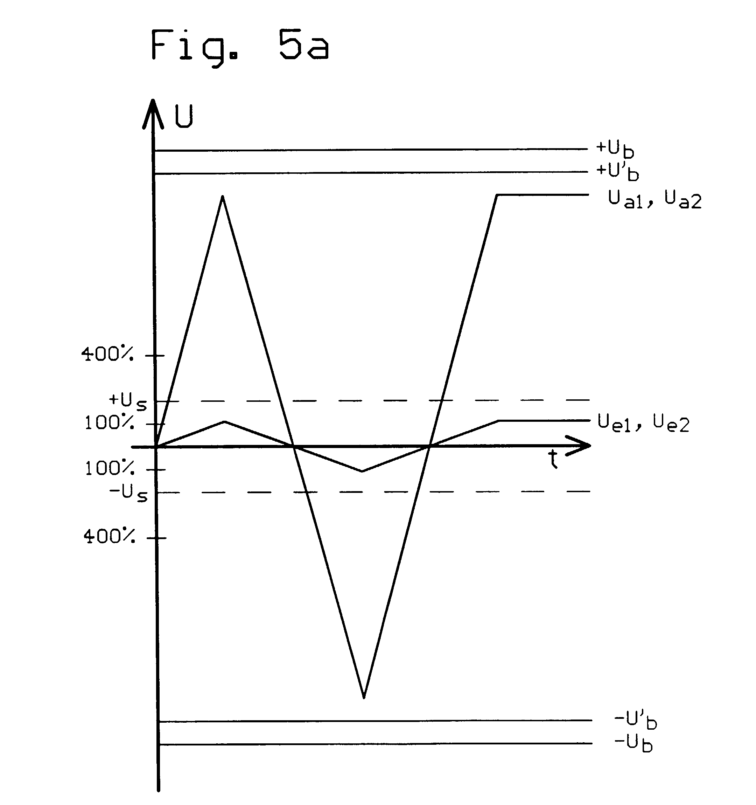

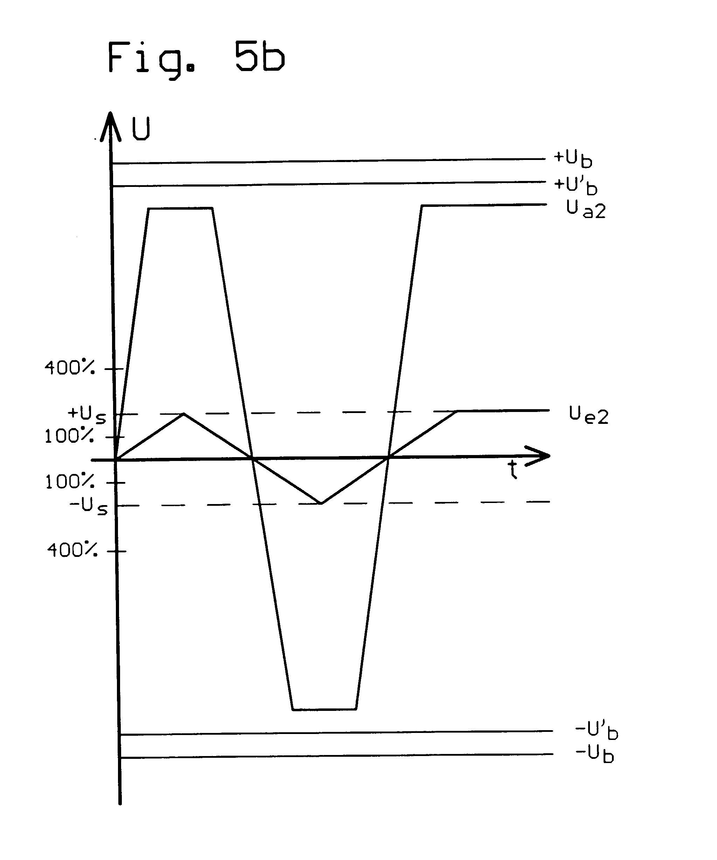

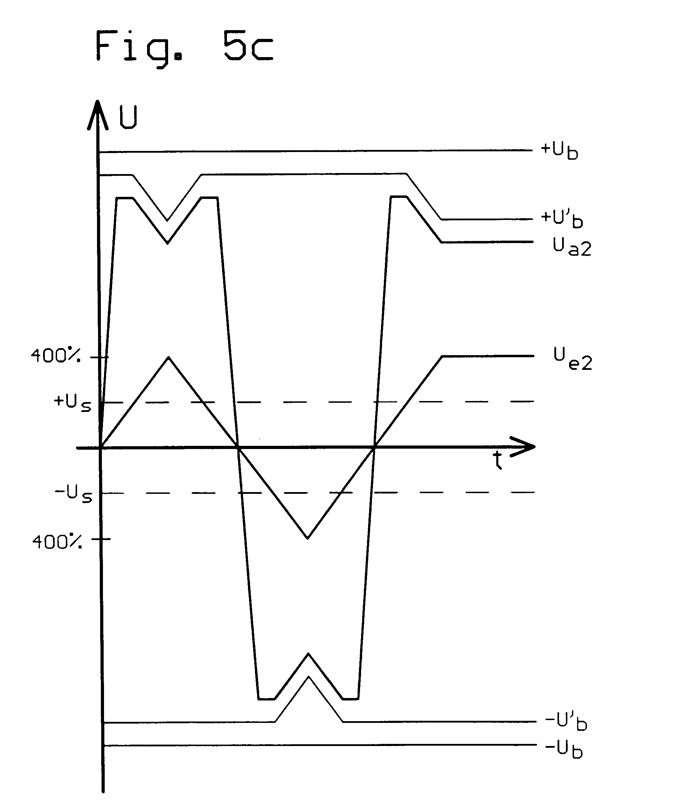

- Fig. 5 a: ein Diagramm des Übertragungsverhaltens der Begrenzerverstärkerschaltung nach Fig. 2 in linearer Ausführung bei l00%iger Eingangsaussteuerung,
- Fig. 5 b: bei 199%iger Eingangsaussteuerung,
- Fig. 5 c: bei 400%iger Eingangsaussteuerung,

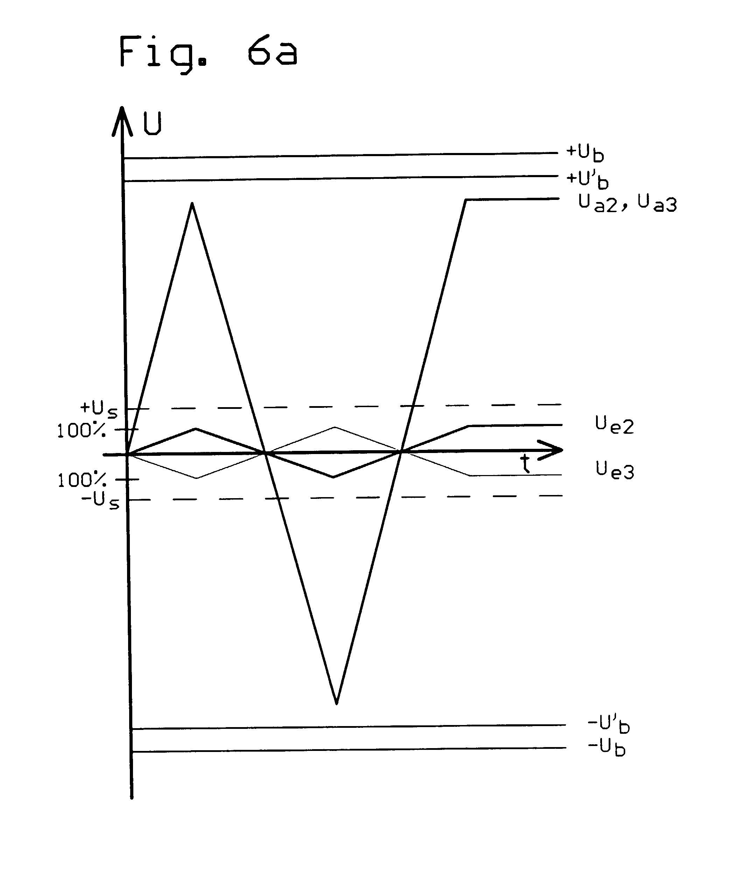

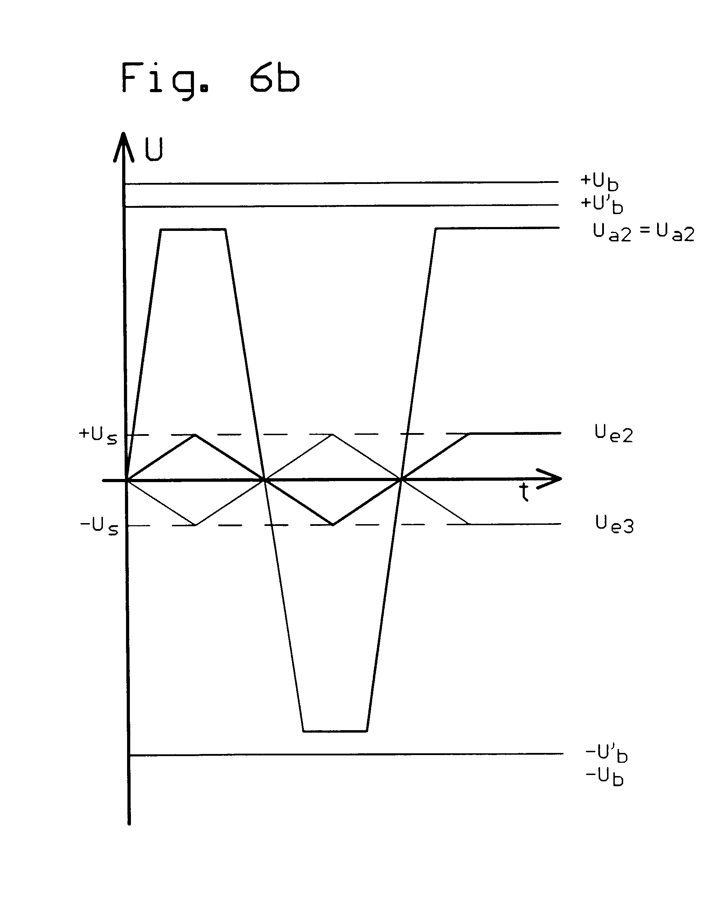

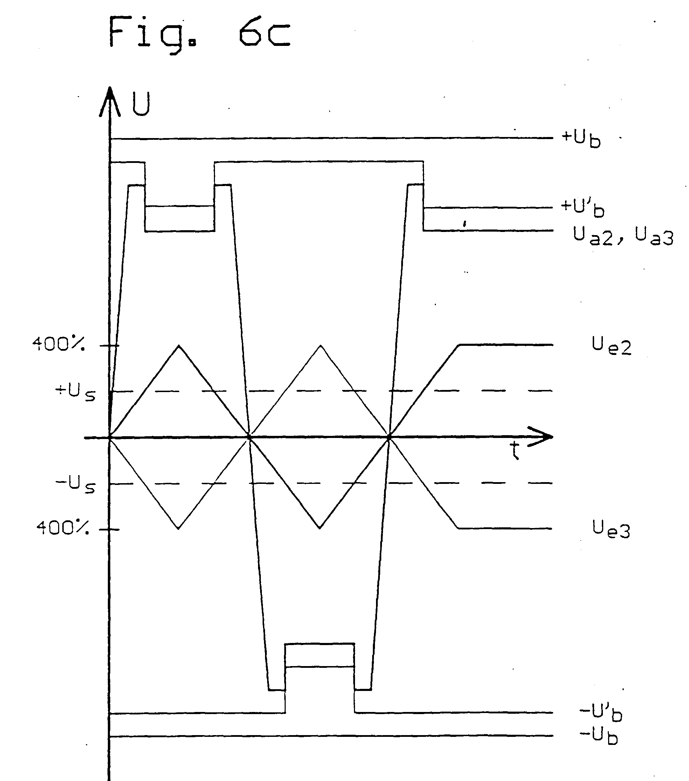

- Fig. 6 a: ein Diagramm des Übertragungsverhaltens der Begrenzerverstärkerschaltung nach Fig. 2 in komparatormäßiger Ausführung bei 100%iger Eingangsaussteuerung,
- Fig. 6 b: bei 199%iger Eingangsaussteuerung und
- Fig. 6 c: bei 400%iger Eingangsaussteuerung.

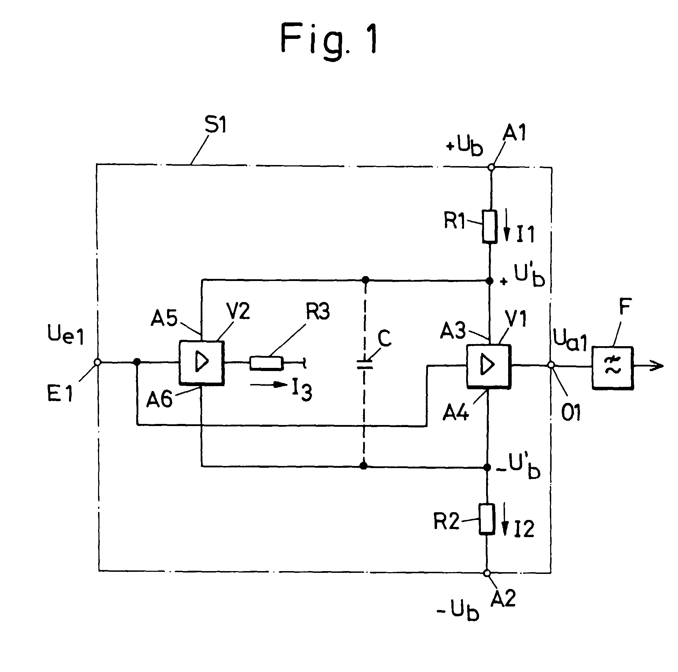

In dem Blockschaltbild nach Fig. 1 bezeichnet S1 eine Begrenzerverstärkerschaltung, die einen ersten und einen zweiten NF-Verstärker V1, V2 mit einem gemeinsamen Eingang E1 für eine niederfrequente Eingangssignalspannung Uₑ₁ aufweist. Anschlüsse A1, A2 der Begrenzerverstärkerschaltung S1 stehen über einen ersten und zweiten Widerstand R1, R2 mit parallelgeschalteten Anschlüssen A3, A4 und A5, A6 der NF-Verstärker V1, V2 in Verbindung. Der Ausgang des zweiten Verstärkers V2 liegt über einen Widerstand R3 auf einem festen Bezugspotential, das ist vorzugsweise das Massepotential. Der Ausgang des ersten Verstärkers V1 bildet den Ausgang O1 der Begrenzerverstärkerschaltung S1, an den sich ein Tiefpaßfilter F anschließt.

In einer alternativen Ausführung der Begrenzerverstärkerschaltung S1 ist den Anschlüssen A3, A4 bzw. A5, A6 ein Kondensator C parallelgeschaltet.

Die Funktion der vorstehend beschriebenen Begrenzerverstärkerschaltung S1 nach Fig. 1 wird im folgenden im Zusammenhang mit den Fig. 4 a und 4 b erläutert.

An den Anschlüssen A1, A2 der Begrenzerverstärkerschaltung S1 liegen die Betriebspotentiale +U_{b} und -U_{b}. Dem Eingang E1 der Begrenzerverstärkerschaltung S1 wird eine niederfrequente Eingangssignalspannung Uₑ₁ zugeführt, die beispielsweise den in Fig. 4 a gezeigten dreieckförmigen Verlauf hat. Die Amplitude der Ausgangsspannung Uₐ₁ nimmt ihren höchsten unbegrenzten Wert an; die zugehörige Eingangsspannungsamplitude wird als 100 % definiert. Die Versorgungsströme I1 und I2 für die Verstärker V1, V2 bewirken an den Widerständen R1 und R2 Spannungsabfälle, die die Betriebsspannungen +U_{b} und -U_{b} auf die wirksamen Betriebsspannungen +U'_{b} und -U'_{b} reduzieren. Die maximale Ausgangsspannung Uₐ₁ hat die Größe der wirksamen Betriebsspannung abzüglich der Ausgangsrestspannung des übersteuerten Verstärkers. Wird, wie in Fig. 4 b dargestellt, das Eingangssignal Uₑ₁ auf 400 % der Linearitätsgrenze erhöht, so wächst der Anteil des Stromes I3 an dem Strom I1 bzw. I2 und somit der durch die jetzt größeren Ströme bewirkte Spannungsabfall an dem Widerstand R1 bzw. R2. Die verringerte wirksame Betriebsspannung +U'_{b}, und -U'_{b} ruft einen früheren Begrenzungseinsatz hervor, so daß die Ausgangsamplitude der Begrenzerverstärkerschaltung S1 proportional zur Eingangsspannung Uₑ₁ sinkt.

Der Verstärker V2 weist vorzugsweise eine geringere Verstärkung als der Verstärker V1 auf. Der in Fig. 1 gestrichelt angedeutete Kondensator C kann zum Glätten des wirksamen Betriebspotentials +U'_{b} und -U'_{b} eingesetzt werden.

Anstelle des Verstärkers V2 und des Widerstandes R3 in Fig. 1 treten bei einer Begrenzerverstärkerschaltung S2 nach dem Blockschaltbild in Fig. 2 zwei Verstärkerstufen V21, V22. In Fig. 2 bezeichnet E2 einen Eingang und O2 den Ausgang der Begrenzerverstärkerschaltung S2. Die parallelgeschalteten positiven Versorgungsanschlüsse A20, A21 und A22 des Verstärkers 20 und der Verstärkerstufen V21 und V22 sind über einen gemeinsamen Widerstand R20 mit dem positiven Betriebspotential +U_{b} verbunden. Der Ausgang der Verstärkerstufe V21 ist über einen Widerstand R22 mit positivem Potential, vorzugsweise dem positiven Betriebspotential +U_{b}, verbunden. Die parallelgeschalteten negativen Versorgungsanschlüsse A23 bis A25 des Verstärkers V20 und der Verstärkerstufen V21 und V22 sind gemeinsam über einen Widerstand R21 mit dem negativen Betriebspotential -U_{b} verbunden. Der Ausgang der Verstärkerstufe V22 steht über einen Widerstand R23 mit einem negativen Potential, vorzugsweise mit dem negativen Betriebspotential -U_{b}, in Verbindung. Durch die Aufteilung des zweiten Verstärkers in zwei Verstärkerstufen V21 und V22 entfällt die Notwendigkeit eines niederohmigen Bezugspotentials.

Die Wirkungsweise der vorstehend beschriebenen Schaltung nach Fig. 2 ist folgende.

Der Verstärker V20 begrenzt durch Clipping die Ausgangsspannung Uₐ₂ auf den Wert der wirksamen Betriebsspannung U'_{b} abzüglich der Ausgangsrestspannung des übersteuerten Verstärkers V20. Der Strom I20 ruft an dem Widerstand R20 einen Spannungsabfall hervor, der das positive Betriebspotential +U_{b} auf die wirksame Betriebsspannung +U'_{b} reduziert. Die Verstärkerstufe V22 hat ihr Ausgangsruhepotential bei annähernd -U_{b}, und der Strom durch den Widerstand R23 ist vernachlässigbar klein. Tritt durch Ansteuerung der Begrenzerverstärkerschaltung S2 ein positives Signal am Ausgang 02 auf, so wird die Ausgangsspannung der Verstärkerstufe V22 ebenfalls positiver. Durch den Widerstand R23 fließt ein Strom I23 zum negativen Betriebspotential -U_{b}. Der erhöhte Strombedarf am Anschluß A22 der Verstärkerstufe V22 ruft durch Erhöhen des Stromes I20 einen höheren Spannungsabfall an dem Widerstand R20 hervor, so daß die wirksame positive Betriebsspannung +U'_{b} sinkt und mit ihr die Größe der begrenzten Ausgangsspannung des Verstärkers V20.

Analog dazu reduziert die Verstärkerstufe V21 durch Erhöhung des Stromes I21 die negative Clippinggrenze. Anders ausgedrückt tritt am Ausgang der ersten Verstärkerstufe V21 nur die negative Halbwelle und am Ausgang der zweiten Verstärkerstufe V22 nur die positive Halbwelle des verstärkten Eingangssignals Uₑ₂ auf, wodurch jede Verstärkerstufe nur bei der ihr zugeordneten Halbwelle das wirksame Betriebspotential +U'_{b} und -U'_{b} des ersten Verstärkers V20 reduziert.

Durch Variation des Gleichspannungspegelversatzes und der Verstärkung der Verstärkerstufen V21 und V22 lassen sich die in den Fig. 4 a bis 6 c gezeigten Übertragungsverhalten der erfindungsgemäßen Begrenzerverstärkerschaltungen erzielen, wobei Uₑ₂ für nichtinvertierende und Uₑ₃ (Fig. 6 a bis 6 c) für invertierende Verstärkerschaltungen gelten.

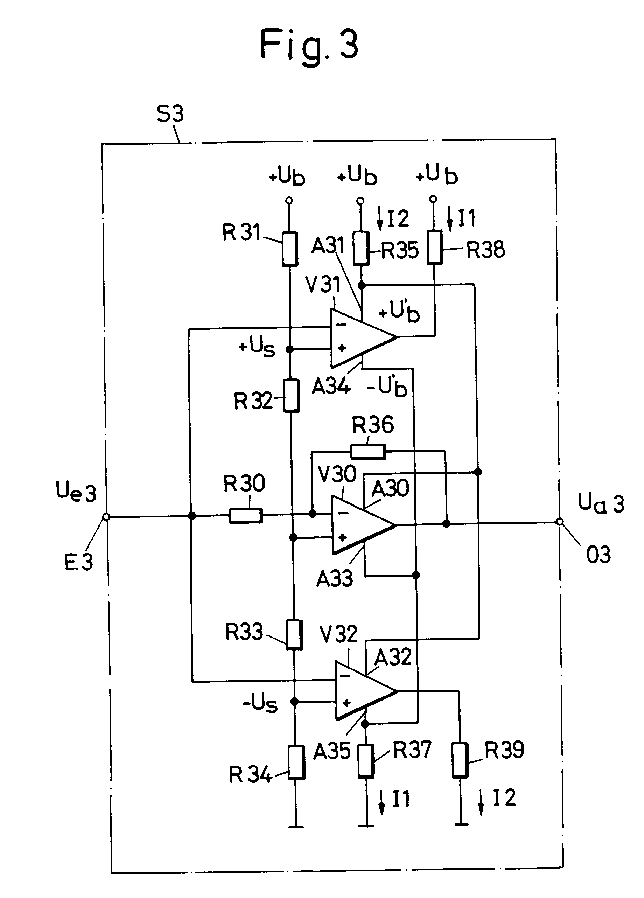

Im folgenden wird eine Begrenzerverstärkerschaltung mit Komparatorverhalten der Verstärkerstufen V21 und V22 in Fig. 2 beschrieben. Diese in Fig. 3 gezeigte Schaltung hat ein Übertragungsverhalten entsprechend den Fig. 6 a bis 6 c.

Eine Begrenzerverstärkerschaltung S3 nach dem Schaltbild in Fig. 3 hat eine unsymmetrische Spannungsversorgung. E3 bezeichnet einen Eingang und 03 einen Ausgang der Begrenzerverstärkerschaltung S3. Zu der Begrenzerverstärkerschaltung S3 gehören ein Verstärker V30 und zwei Verstärkerstufen V31 und V32, die vorzugsweise Operationsverstärker sind. Der Eingang E3 ist über einen Widerstand R30 mit einem invertierenden Eingang des Verstärkers V30 verbunden. Der invertierende Eingang und der Ausgang des Verstärkers V30 sind über einen Widerstand R36 überbrückt. Der Ausgang des Verstärkers V30 bildet den Ausgang 03 der Begrenzerverstärkerschaltung S3. Der Eingang E3 ist weiterhin mit je einem invertierenden Eingang der Verstärkerstufen V31 und V32 verbunden. Zwischen dem positiven Betriebspotential +U_{b} und Masse liegt ein Spannungsteiler aus vier Widerständen R31, R32, R33 und R34. Zwischen den Widerständen R31 und R32 zweigt eine erste Verbindung zu einem nichtinvertierenden Eingang der ersten Verstärkerstufe V31 ab, zwischen den Widerständen R32 und R33 eine zweite Verbindung zu dem nichtinvertierenden Eingang des Verstärkers V30 und zwischen den Widerständen R33 und R34 eine Verbindung zu dem nichtinvertierenden Eingang der zweiten Verstärkerstufe V32 ab. Anschlüsse A30 bis A32 des Verstärkers V30 und der Verstärkerstufen V31, V32 sind miteinander verbunden und stehen gemeinsam über einen Widerstand R35 mit dem positiven Betriebspotential +U_{b} in Verbindung. Anschlüsse A33 bis A35 sind ebenfalls untereinander verbunden und stehen über einen weiteren Widerstand R37 mit dem Bezugspotential in Verbindung. Der Ausgang der ersten Verstärkerstufe V31 liegt über einen Widerstand R38 auf dem positiven Betriebspotential +U_{b} und der Ausgang der zweiten Verstärkerstufe V32 über einen Widerstand R39 auf dem Bezugspotential.

Die Wirkungsweise der vorstehend beschriebenen Begrenzerverstärkerschaltung S3 (Fig. 3) ist folgende.

Der Verstärker V30 begrenzt durch Clipping die Ausgangssignalspannung Uₐ₃. Überschreitet die Eingangssignalspannung Uₑ₃ einen Schwellwert ±Uₛ (Fig. 6 a bis 6 c), der beispielsweise 200 % derjenigen Eingangsspannung Uₑ₃ entspricht, bei der das Clipping durch die Begrenzerverstärkerschaltung S3 beginnt, so wirken die als Komparator geschalteten Verstärkerstufen V31 und V32 wie Schalter, das heißt die Verstärkerstufe V31 gibt ein von H nach L wechselndes Ausgangssignal ab. Durch den Widerstand R38 fließt dann ein Strom I1, der auch am Anschluß A34 erscheint und an dem Widerstand R37 einen zusätzlichen Spannungsabfall erzeugt. Dieser Spannungsabfall reduziert das wirksame Betriebspotential -U'_{b} für den Verstärker V30, so daß das Clipping bereits früher einsetzt. In analoger Weise reduziert der durch die Widerstände R35 und R39 fließende Strom I2 die positive Clippinggrenze des Ausgangssignals Uₐ₃.

Die Fig. 6 a bis 6 c zeigen den zeitlichen Verlauf der Spannungen Uₑ, Uₐ, +U_{b}, -U_{b}, +U'_{b}, -U'_{b} nach Fig. 2 und 3, wobei nach dem Beispiel in Fig. 3 das Betriebspotential -U_{b} gleich dem Massepotential ist und Uₑ₃ das Eingangssignal darstellt. In den Beispielen nach Fig. 6 a bis 6 c entspricht Uₑ₂ dem Eingangssignal nichtinvertierender Verstärker.

## Patentansprüche

1. Begrenzerverstärkerschaltung für eine niederfrequente Eingangssignalspannung mit einem ersten Verstärker, der die niederfrequente Eingangsspannung durch Clipping begrenzt, **dadurch gekennzeichnet,** daß die Begrenzerverstärkerschaltung (S1) einen zweiten, durch die niederfrequente Eingangssignalspannung (Uₑ₁) angesteuerten Verstärker (V2) aufweist, der bei einer Übersteuerung des ersten Verstärkers (V1) die wirksame Betriebsspannung (±U'_{b}) für den ersten Verstärker (V1) reduziert.

2. Begrenzerverstärkerschaltung nach Anspruch 1, dadurch gekennzeichnet, daß der Ausgang des zweiten Verstärkers (V2) über einen dritten Widerstand (R3) mit einem festen Bezugspotential verbunden ist, daß die Anschlüsse (A3, A5; A4, A6) für die Stromversorgung von erstem und zweitem Verstärker (V1, V2) miteinander verbunden sind und daß der positive Anschluß (A5) über einen ersten Widerstand (R1) mit dem positiven Betriebspotential (+U_{b}) und der negative Anschluß (A6) über einen zweiten Widerstand (R2) mit dem negativen Betriebspotential (-U_{b}) verbunden sind.

3. Begrenzerverstärkerschaltung nach Anspruch 2, dadurch gekennzeichnet, daß die positiven Anschlüsse (A3, A5) und die negativen Anschlüsse (A4, A6) von erstem und zweitem Verstärker (V1, V2) über einen Kondensator (C) miteinander verbunden sind.

4. Begrenzerverstärkerschaltung nach einem der Ansprüche 1 bis 3, dadurch gekennzeichnet, daß die Funktion des zweiten Verstärkers (V2) auf zwei Verstärkerstufen (V21, V22) aufgeteilt ist und daß die Ausgänge der beiden Verstärkerstufen über je einen Widerstand (R22, R23) mit verschiedenen Betriebspotentialen (+U_{b}, -U_{b}) verbunden sind.

5. Begrenzerverstärkerschaltung nach Anspruch 4, dadurch gekennzeichnet, daß je eine Verstärkerstufe (V21) einen Teil der Halbwelle der jeweils anderen Verstärkerstufe (V22) mitverarbeitet.

6. Begrenzerverstärkerschaltung nach einem der Ansprüche 4 oder 5, dadurch gekennzeichnet, daß die Verstärkerstufen (V21, V22) derart dimensioniert sind, daß sie die wirksamen Betriebspotentiale (+U'_{b}, -U'_{b}) des ersten Verstärkers (V20) erst dann reduzieren, wenn die niederfrequente Eingangsspannung (Uₑ₂) einen bestimmten, vorgegebenen Pegel (±Uₛ) überschreitet.

7. Begrenzerverstärkerschaltung nach einem der Ansprüche 4 bis 6, dadurch gekennzeichnet, daß die Verstärkerstufen (V21, V22) ein Komparatorverhalten aufweisen.

## Claims

1. Limiter amplifier circuit for an audio-frequency input signal voltage having a first amplifier which limits the audio-frequency input voltage by clipping, characterized in that the limiter amplifier circuit (S1) has a second amplifier (V2) which is driven by the audio-frequency input signal voltage (Uₑ₁) and reduces the effective operating voltage (±U'_{b}) for the first amplifier (V1) if the first amplifier (V1) is being overdriven.

2. Limiter amplifier circuit according to Claim 1, characterized in that the output of the second amplifier (V2) is connected to a fixed reference-earth potential via a third resistor (R3), in that the connections (A3, A5; A4, A6) for the power supply of the first and of the second amplifier (V1, V2) are connected to one another, and in that the positive connection (A5) is connected to the positive operating potential (+U_{b}) via a first resistor (R1), and the negative connection (A6) is connected to the negative operating potential (-U_{b}) via a second resistor (R2).

3. Limiter amplifier circuit according to Claim 2, characterized in that the positive connections (A3, A5) and the negative connections (A4, A6) of the first and of the second amplifier (V1, V2) are connected to one another via a capacitor (C).

4. Limiter amplifier circuit according to one of Claims 1 to 3, characterized in that the function of the second amplifier (V2) is split between two amplifier stages (V21, V22), and in that the outputs of the two amplifier stages are connected to different operating potentials (+U_{b}, -U_{b}) via in each case one resistor (R22, R23).

5. Limiter amplifier circuit according to Claim 4, characterized in that in each case one amplifier stage (V21) jointly processes a part of the half cycle of the respectively other amplifier stage (V22).

6. Limiter amplifier circuit according to one of Claims 4 or 5, characterized in that the amplifier stages (V21, V22) are designed in such a manner that they do not reduce the effective operating potentials (+U'_{b}, -U'_{b}) of the first amplifier (V20) until the audio-frequency input voltage (Uₑ₂) exceeds a specific, predetermined level (±Uₛ).

7. Limiter amplifier circuit according to one of Claims 4 to 6, characterized in that the amplifier stages (V21, V22) have a comparator behaviour.

## Revendications

1. Circuit amplificateur-limiteur pour une tension de signal d'entrée basse fréquence comprenant un premier amplificateur limitant la tension d'entrée basse fréquence par écrêtage,
caractérisé en ce que
le circuit amplificateur-limiteur (S1) comprend un second amplificateur (V2) commandé par la tension du signal d'entrée (Uₑ₁) basse fréquence, cet amplificateur réduisant la tension de fonctionnement efficace (±U'_{b}) du premier amplificateur (V1) en cas de surcharge de commande du premier amplificateur (V1).

2. Circuit amplificateur-limiteur selon la revendication 1,
caractérisé en ce que
la sortie du second amplificateur (V2) est reliée par l'intermédiaire d'une troisième résistance (R3) à un potentiel de référence fixe, les branchements (A3, A5 ; A4, A6) de l'alimentation en courant du premier et du second amplificateur (V1, V2) étant reliés l'un à l'autre et le branchement positif (A3) est relié par une première résistance (R1) au potentiel de fonctionnement positif (+U_{b}) et le branchement négatif (A6) est relié par une seconde résistance (R2) au potentiel de fonctionnement négatif (-U_{b}).

3. Circuit amplificateur-limiteur selon la revendication 2,
caractérisé en ce que
les branchements positifs (A3, A5) et les branchements négatifs (A4, A6) du premier et du second amplificateur (V1, V2) sont reliés par un condensateur (C).

4. Circuit amplificateur-limiteur selon l'une des revendications 1 à 3,
caractérisé en ce que
le rôle du second amplificateur (V2) est subdivisé en deux étages amplificateurs (V21, V22) et les sorties de ces deux étages amplificateurs sont reliées chaque fois par une résistance (R22, R23) aux différents potentiels de fonctionnement (+U_{b}, -U_{b}).

5. Circuit amplificateur-limiteur selon la revendication 4,
caractérisé en ce que
chaque étage amplificateur (V21) traite une partie de la demi-onde de chaque autre étage amplificateur (V22).

6. Circuit amplificateur-limiteur selon l'une quelconque des revendications 4 ou 5,
caractérisé en ce que
les étages amplificateurs (V21, V22) sont dimensionnés pour réduire les potentiels de fonctionnement efficaces (+U'_{b},-U'_{b}) du premier amplificateur (V20) seulement lorsque la tension d'entrée basse fréquence (Uₑ₂) dépasse un certain niveau prédéterminé (+Uₛ).

7. Circuit amplificateur-limiteur selon l'une des revendications 4 à 6,
caractérisé en ce que
les étages amplificateurs (V21, V22) ont un comportement de comparateur.
